# EUROPEAN PATENT SPECIFICATION

(11) **EP 4 617 695 B1**
(45) Date of publication and mention of the grant of the patent: **07.10.2026**
(21) Application number: 23903930.8
(22) Date of filing: 11.12.2023
(51) Int. Cl.: G01R 31/52, G01R 31/385, G01R 19/10, G01R 19/00, G01R 19/165, G01R 31/367, G01R 31/396, B60R 16/033

(54) **APPARATUS AND METHOD FOR DIAGNOSING BATTERY**
BATTERIEDIAGNOSEVORRICHTUNG UND -VERFAHREN
DISPOSITIF ET PROCÉDÉ DE DIAGNOSTIC DE BATTERIE

(30) Priority: 12.12.2022 KR 20220172883
(43) Date of publication of application: 17.09.2025
(73) Proprietor: LG Energy Solution, Ltd., Seoul 07335 (KR)
(72) Inventor: KIM, Ki-Hoon, Daejeon 34122 (KR); PARK, Han-Gon, Daejeon 34122 (KR); LEE, Bo-Kyun, Daejeon 34122 (KR); SONG, Chang-Yong, Daejeon 34122 (KR)
(74) Representative: Plasseraud IP
(86) International application number: PCT/KR2023/020335
(87) International publication number: WO 2024/128727

(56) References cited:
- CN-A- 113 219 361
- KR-A- 20150 097 340
- KR-A- 20190 075 609
- KR-A- 20210 059 566
- KR-A- 20210 131 783
- KR-A- 20220 036 701
- KR-A- 20220 036 701
- US-A1- 2021 296 911
- US-A1- 2022 352 737

## Description

### TECHNICAL FIELD

The present application claims priority to Korean Patent Application No. 10-2022-0172883 filed on December 12, 2022 in the Republic of Korea.

The present disclosure relates to an apparatus and method for diagnosing a battery, and more particularly, to an apparatus and method for diagnosing a battery, which is capable of diagnosing an internal micro short circuit of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

An energy storage system using such a battery may be a device that stores large-scale power and provides the stored power to a plurality of load facilities. For example, the energy storage system is used in the form of industrial, building, or home energy management systems, and is used as a permanent power grid and/or an emergency power grid by providing stored power at each point of use to load facilities.

If a micro short circuit occurs inside the battery, leakage current from the battery may occur. For example, it is assumed that a plurality of batteries are included in a battery pack. If an internal micro short circuit occurs in any battery and leakage current occurs, the voltage of that battery may gradually decrease compared to the voltages of other batteries. Also, if this phenomenon continues, a hard short circuit may occur, causing permanent damage to the battery pack.

A prior art battery cell diagnostic arrangement is known from CN113219361A.

Therefore, there is a need to develop technology that may diagnose in advance whether a micro short circuit has occurred inside the battery.

### DISCLOSURE

### Technical Problem

The present disclosure is designed to solve the problems of the related art, and therefore the present disclosure is directed to providing an apparatus and method for diagnosing a battery, which may diagnose whether an internal micro short circuit occurs in a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a voltage measuring unit configured to measure voltages of a plurality of batteries; and a control unit configured to calculate a voltage deviation of the plurality of batteries, calculate a voltage deviation change amount of each of the plurality of batteries, and diagnose a state of each of the plurality of batteries based on the voltage deviation change amount and a calculation period of the voltage deviation change amount.

The control unit is configured to determine a diagnostic score of each of the plurality of batteries from the voltage deviation change amount and the calculation period based on a preset score table, and diagnose the state of each battery according to a cumulative diagnostic score of each of the plurality of batteries.

The control unit may be configured to determine a battery of which the cumulative diagnostic score is higher than or equal to a preset reference value among the plurality of batteries and diagnose that an internal micro short circuit has occurred in the determined battery.

The control unit may be configured to determine a corresponding diagnostic score by substituting the voltage deviation change amount and the calculation period in the score table.

The control unit may be configured to determine the diagnostic score based on a first score table when the voltage deviation change amount is a positive number and determine the diagnostic score based on a second score table when the voltage deviation change amount is a negative number or 0.

The first score table may be configured so that a higher score is set as the voltage deviation change amount is higher and the calculation period is shorter.

The second score table may be configured so that a lower score is set as the voltage deviation change amount is lower and the calculation period is shorter.

The control unit may be configured to calculate a current voltage deviation of the plurality of batteries at a second time point after a predetermined period has elapsed from a first time point when the voltage deviation is calculated, and calculate the voltage deviation change amount by calculating a difference between the voltage deviation and the current voltage deviation.

The control unit may be configured to calculate a current voltage deviation of the plurality of batteries at a second time point after a predetermined period has elapsed from the first time point when the voltage deviation is calculated, and calculate the calculation period by calculating a difference between the first time point and the second time point.

The control unit may be configured to calculate an average voltage of the plurality of batteries, and calculate a voltage deviation of each of the plurality of batteries by calculating a difference between the calculated average voltage and the voltage of each of the plurality of batteries.

A battery pack according to another aspect of the present disclosure may comprise the apparatus for diagnosing a battery according to one aspect of the present disclosure.

A vehicle according to another aspect of the present disclosure may comprise the apparatus for diagnosing a battery according to one aspect of the present disclosure.

A method for diagnosing a battery according to still another aspect of the present disclosure comprises: a voltage measuring step of measuring voltages of a plurality of batteries; a voltage deviation calculating step of calculating a voltage deviation of the plurality of batteries; a voltage deviation change amount calculating step of calculating a voltage deviation change amount of each of the plurality of batteries; and a diagnosing step of diagnosing a state of each of the plurality of batteries based on the voltage deviation change amount and a calculation period of the voltage deviation change amount, comprising a determination of a diagnostic score of each of the plurality of batteries from the voltage deviation change amount and the calculation period based on a preset score table, and diagnosing the state of each battery according to a cumulative diagnostic score of each of the plurality of batteries.

### Advantageous Effects

According to one aspect of the present disclosure, the apparatus for diagnosing a battery may diagnose the state of each battery by tracking the trend of the voltage deviation change amount of the battery.

Additionally, according to one aspect of the present disclosure, the state of the battery may be quantified in the form of a diagnostic score, so the state of the battery may be diagnosed on an objective basis.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a voltage for a plurality of battery cells according to an embodiment of the present disclosure.
FIG. 3 is a diagram schematically showing a voltage deviation change amount according to an embodiment of the present disclosure.
FIG. 4 is a diagram schematically showing a first score table according to an embodiment of the present disclosure.
FIG. 5 is a diagram schematically showing a second score table according to an embodiment of the present disclosure.
FIG. 6 is a diagram schematically showing a first diagnostic example according to an embodiment of the present disclosure.
FIG. 7 is a diagram schematically showing a second diagnostic example according to an embodiment of the present disclosure.
FIG. 8 is a diagram schematically showing an exemplary configuration of a battery pack according to another embodiment of the present disclosure.
FIG. 9 is a diagram schematically showing a vehicle according to another embodiment of the present disclosure.
FIG. 10 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

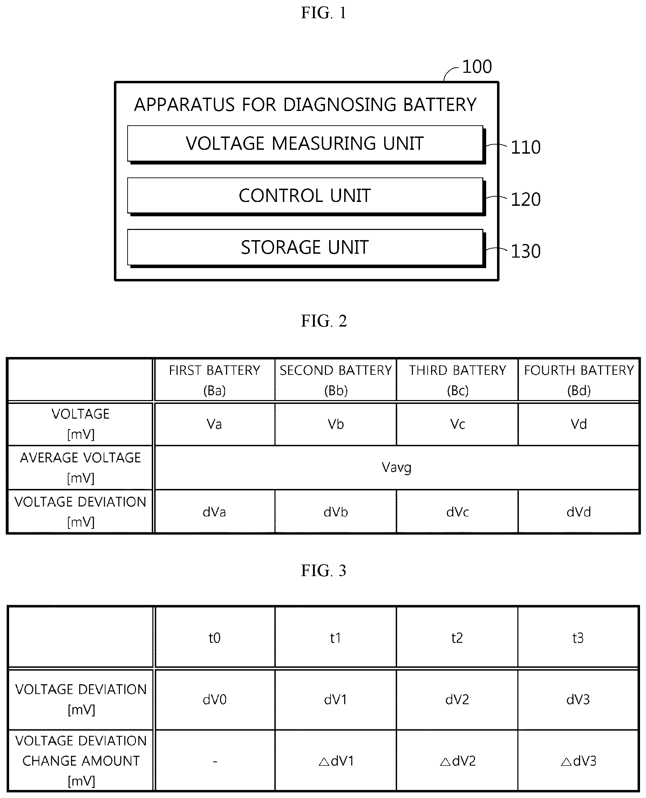

FIG. 1 is a diagram schematically illustrating an apparatus 100 for diagnosing a battery according to an embodiment of the present disclosure.

Referring to FIG. 1, the apparatus 100 for diagnosing a battery may include a voltage measuring unit 110 and a control unit 120.

Here, the battery refers to an independent cell that has a negative electrode terminal and a positive electrode terminal and is physically separable. As an example, a lithium-ion cell or a lithium polymer cell may be considered a battery. Hereinafter, for convenience of explanation, the battery is explained as meaning one independent cell.

The voltage measuring unit 110 may be configured to measure voltages of a plurality of batteries.

Specifically, the voltage measuring unit 110 may be configured to measure the voltage of each of the plurality of batteries.

FIG. 2 is a diagram schematically showing a voltage for a plurality of battery cells according to an embodiment of the present disclosure.

In the embodiment of FIG. 2, it is assumed that a first battery Ba, a second battery Bb, a third battery Bc, and a fourth battery Bd are provided. The voltage measuring unit 110 may measure the voltage of the first battery Ba as Va, the voltage of the second battery Bb as Vb, the voltage of the third battery Bc as Vc, and the voltage of the fourth battery Bd as Vd.

Additionally, the voltage measuring unit 110 may be connected to enable communication with the control unit 120. For example, the voltage measuring unit 110 and the control unit 120 may be connected wired and/or wirelessly. The voltage measuring unit 110 may transmit information about the measured voltage to the control unit 120.

The control unit 120 may be configured to calculate the voltage deviation of the plurality of batteries.

Specifically, the control unit 120 may receive voltage information of the plurality of batteries from the voltage measuring unit 110 and calculate the voltage deviation of the plurality of batteries based on the received voltage information.

First, the control unit 120 may be configured to calculate the average voltage of the plurality of batteries. In the embodiment of FIG. 2, the control unit 120 may calculate the average voltage for the voltages of the first to fourth batteries Ba, Bb, Bc, Bd. For example, the control unit 120 may calculate the average voltage as Vavg by calculating the formula "(Va + Vb + Vc + Vd) ÷ 4".

Next, the control unit 120 may be configured to calculate the voltage deviation of each of the plurality of batteries by calculating the difference between the calculated average voltage and the voltage of each of the plurality of batteries. In the embodiment of FIG. 2, the control unit 120 may calculate the voltage deviation of the first to fourth batteries Ba, Bb, Bc, Bd by calculating the difference between the voltages of the first to fourth batteries Ba, Bb, Bc, Bd and the average voltage. For example, the control unit 120 may calculate the voltage deviation of the first battery Ba as dVa by calculating the formula "|Va - Vavg|", and calculate the voltage deviation of the second battery Bb as dVb by calculating the formula "|Vb - Vavg|". Also, control unit 120 may calculate the voltage deviation of the third battery Bc as dVc by calculating the formula "|Vc - Vavg|", and may calculate the voltage deviation of the fourth battery Bd as dVd by calculating the formula "|Vd - Vavg|". Here, "∥" is an absolute value symbol, and the calculated voltage deviation may be expressed as the absolute value of the difference between the battery voltage and the average voltage.

The control unit 120 may be configured to calculate the voltage deviation change amount for each of the plurality of batteries.

Specifically, the control unit 120 may calculate the voltage deviation of each of the plurality of batteries. Here, the voltage deviation may be a voltage deviation of the plurality of batteries measured at the current time point. Additionally, the control unit 120 may calculate the voltage deviation change amount between the voltage deviation calculated at the previous time point and the voltage deviation calculated at the current time point, for each of the plurality of batteries.

FIG. 3 is a diagram schematically showing a voltage deviation change amount according to an embodiment of the present disclosure. Specifically, the embodiment of FIG. 3 is a diagram showing only the voltage deviation of the first battery Ba among the voltage deviations of the first to fourth batteries Ba, Bb, Bc, Bd calculated at time points t0, t1, t2, and t3. Here, t0, t1, t2, and t3 may be time points when the voltages of the first to fourth batteries Ba, Bb, Bc, Bd are measured.

Meanwhile, in FIG. 3, only the voltage deviation of the first battery Ba is shown, but note that the voltage deviations of the second to fourth batteries Bb, Bc, Bd are also calculated to diagnose the state of the second to fourth batteries Bb, Bc, Bd.

In the embodiment of FIG. 3, the voltage deviation of the first battery Ba calculated at the t0 time point is dV0, the voltage deviation of the first battery Ba calculated at the t1 time point is dV1, the voltage deviation of the first battery Ba calculated at the t2 time point is dV2, and the voltage deviation of the first battery Ba calculated at the t3 time point is dV3. The control unit 120 may calculate the voltage deviation change amount as △dV1 by calculating the difference between the voltage deviations at the t0 time point and the t1 time point according to the formula "dV1 - dVO". The control unit 120 may calculate the voltage deviation change amount as △dV2 by calculating the difference between the voltage deviations at the t1 time point and the t2 time point according to the formula "dV2 - dV1". The control unit 120 may calculate the voltage deviation change amount as △dV3 by calculating the difference between the voltage deviations at the t3 time point and the t2 time point according to the formula "dV3 - dV2".

The control unit 120 may be configured to diagnose the state of each of the plurality of batteries based on the voltage deviation change amount and the calculation period of the voltage deviation change amount.

Specifically, the control unit 120 may be configured to calculate the current voltage deviation of the plurality of batteries at a second time point after a predetermined period has elapsed from the first time point when the voltage deviation is calculated.

For example, in the embodiment of FIG. 3, the t1 time point may be a time point after a predetermined period has elapsed from the t0 time point. Here, assuming that the predetermined period is set to 10 days, the difference between the t0 time point and the t1 time point may be 10 days or more. Likewise, the t2 time point may be a time point after a predetermined period has elapsed from the t1 time point. Additionally, the t3 time point may be a time point after a predetermined period has elapsed from the t2 time point.

If, in the embodiment of FIG. 3, the t3 time point is a time point before a predetermined period has elapsed from the t2 time point (e.g., the difference between the t2 time point and the t3 time point is less than 10 days), at the t3 time point, the voltage deviation and the voltage deviation change amount may not be calculated. Assuming that the time point after a predetermined period has elapsed from the t2 time point is the t4 time point (a time point after the t3 time point), the control unit 120 may calculate the voltage deviation of the first battery Ba at the t4 time point as dV4. In addition, the control unit 120 may calculate the voltage deviation change amount at the t4 time point as △dV4 by calculating the difference between the voltage deviations at the t4 time point and the t2 time point according to the formula "dV4 - dV2".

The control unit 120 may be configured to calculate the voltage deviation change amount by calculating the difference between the voltage deviation and the current voltage deviation. Additionally, the control unit 120 may be configured to calculate the calculation period by calculating the difference between the first time point and the second time point.

For example, in the embodiment of FIG. 3, the state of the first battery Ba may be diagnosed based on 1) the first calculation period and △dV1 according to the difference between the t0 time point and the t1 time point, 2) the second calculation period and △dV2 according to the difference between the t1 time point and the t2 time point, and 3) the third calculation period and △dV3 according to the difference between the t2 time point and the t3 time point.

The apparatus 100 for diagnosing a battery according to an embodiment of the present disclosure may diagnose the state of a single battery by considering all the voltage deviation of the plurality of batteries, the voltage deviation change amount of a single battery, and the calculation period of the voltage deviation change amount. In other words, the apparatus 100 for diagnosing a battery may individually diagnose the state of each battery by tracking the trend of the voltage deviation change amount of the battery.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may be connected to communicate with the control unit 120. The storage unit 130 may store voltage information of a plurality of batteries measured by the voltage measuring unit 110. Additionally, the storage unit 130 may store the voltage deviation and voltage deviation change amount of the plurality of batteries calculated by the control unit 120 at each predetermined cycle.

The control unit 120 may be configured to determine the diagnostic score of each of the plurality of batteries from the voltage deviation change amount and the calculation period based on a preset score table.

Here, the score table may be a table in which a diagnostic score is set according to the score set in the voltage deviation change amount and the score set in the calculation period. Preferably, the score table may be configured to set a higher score as the voltage deviation increases (i.e., as the voltage deviation change amount increases).

Specifically, the control unit 120 may be configured to determine the corresponding diagnostic score by substituting the voltage deviation change amount and the calculation period in the score table. That is, the control unit 120 may determine the diagnostic score corresponding to the current time point by substituting the voltage deviation change amount and the calculation period calculated at the current time point into the score table.

For example, in the embodiment of FIG. 3, the control unit 120 may determine the first diagnostic score by substituting the first calculation period and △dV1 according to the difference between the t0 time point and the t1 time point into the score table. Additionally, the control unit 120 may determine the second diagnostic score by substituting the second calculation period and △dV2 according to the difference between the t1 time point and the t2 time point into the score table. Additionally, the control unit 120 may determine the third diagnostic score by substituting the third calculation period and △dV3 according to the difference between the t2 time point and the t3 time point into the score table. Additionally, the control unit 120 may diagnose the state of the first battery Ba based on at least one of the first diagnostic score, the second diagnostic score, and the third diagnostic score.

The control unit 120 may compare the determined diagnostic score and a preset reference value and diagnose the state of the battery according to the comparison result. For example, if the determined diagnostic score is greater than or equal to the preset reference value, the control unit 120 may diagnose that an internal micro short circuit has occurred in the battery. Conversely, the control unit 120 may diagnose the battery as normal if the determined diagnostic score is less than the preset reference value.

The apparatus 100 for diagnosing a battery according to an embodiment of the present disclosure may determine a diagnostic score for a battery using a preset score table. Additionally, because the apparatus 100 for diagnosing a battery diagnoses the state of the battery according to the determined diagnostic score, it has the advantage of being able to quickly diagnose the state of a plurality of batteries using the same standard.

The control unit 120 may be configured to diagnose the state of each battery according to the cumulative diagnostic score of each of the plurality of batteries.

Specifically, the control unit 120 may not diagnose the state of the battery only based on the diagnostic score determined at any one time point, but may diagnose the state of the battery based on the sum (cumulative diagnostic score) of diagnostic scores determined at a plurality of time points.

For example, the diagnostic score determined at a certain time point may contain an error due to voltage measurement noise or communication noise. If the state of the battery is diagnosed based on a diagnostic score that includes errors, there is a problem that the state of the battery may be diagnosed incorrectly. Therefore, the control unit 120 may diagnose the state of the battery based on the cumulative diagnostic score.

Preferably, the control unit 120 may be configured to determine a battery whose cumulative diagnostic score is greater than or equal to the preset reference value among the plurality of batteries.

For example, the reference value may be preset to 20 points. The control unit 120 may calculate a cumulative diagnostic score by adding up all diagnostic scores at a plurality of time points. Additionally, the control unit 120 may diagnose the state of the battery by comparing the calculated cumulative diagnostic score and the preset reference value.

Preferably, in order to diagnose the state of the battery based on the cumulative diagnostic score, the reference value may be preset to a value greater than the maximum value set in the score table. For example, if the maximum value set in the score table is 16, the reference value may be set to 20.

Additionally, the control unit 120 may be configured to diagnose that an internal micro short circuit has occurred in the determined battery. Conversely, the control unit 120 may diagnose the battery as normal if the determined cumulative diagnostic score is less than the preset reference value.

For example, the voltage deviation of a battery having an internal micro short circuit with respect to other batteries may gradually increase as time passes. Therefore, since a battery whose cumulative diagnostic score is higher than or equal to the reference value is a battery whose voltage deviation from other batteries is gradually increasing, the control unit 120 may diagnose that an internal micro short circuit has occurred in this battery.

The apparatus 100 for diagnosing a battery according to an embodiment of the present disclosure may more accurately diagnose the state of the battery by diagnosing the state of the battery based on the cumulative diagnostic score at a plurality of time points.

In one embodiment, the score table may include a first score table T1 and a second score table T2. Here, the first score table T1 may be a score table used when the voltage deviation change amount is a positive number, and the second score table T2 may be a score table used when the voltage deviation change amount is a negative number or 0.

The control unit 120 may be configured to determine a diagnostic score based on the first score table T1 when the voltage deviation change amount is a positive number.

If the voltage deviation change amount is a positive number, it may indicate that the voltage deviation of the battery is gradually increasing. Also, if the voltage deviation change amount is large despite the calculation period being short, it may indicate that the state of the battery is rapidly deteriorating. Therefore, when the voltage deviation change amount is a positive number, the score corresponding to the voltage deviation change amount may be set to a positive number so that the cumulative diagnostic score may be increased. In other words, the first score table T1 may be configured so that a higher score is set as the voltage deviation change amount is higher and the calculation period is shorter.

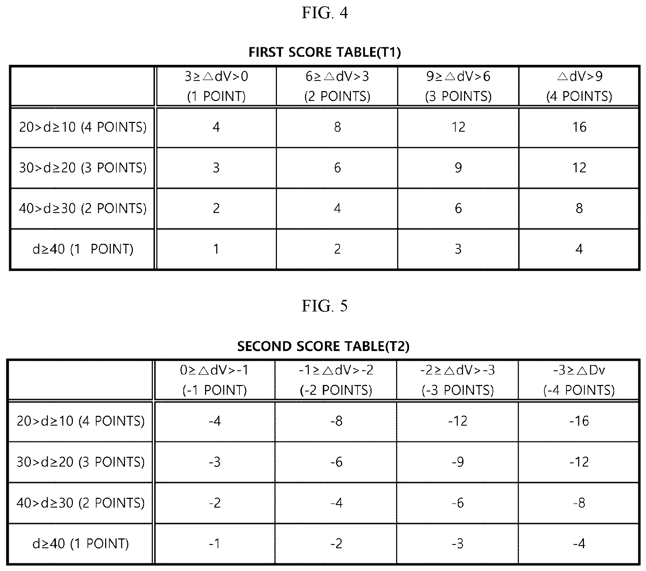

FIG. 4 is a diagram schematically showing a first score table T1 according to an embodiment of the present disclosure. Note that the calculation period section, the voltage deviation change amount section, and the score included in the embodiment of FIG. 4 are examples and values can be changed.

In the embodiment of FIG. 4, the calculation period may be set to 4 points if it is 10 days or more and less than 20 days, 3 points if it is 20 days or more and less than 30 days, 2 points if it is 30 days or more and less than 40 days, and 1 point if it is 40 days or more. Additionally, the voltage deviation change amount may be set to 1 point if it is more than 3 and 6 or less, 2 points if it is more than 6 and 9 or less, 3 points if it is more than 6 and 9 or less, and 4 points if it is more than 9.

The control unit 120 may be configured to determine a diagnostic score based on the second score table T2 when the voltage deviation change amount is a negative number or 0.

If the voltage deviation change amount is a negative number or 0, it may indicate that the voltage deviation of the battery does not increase. Also, even though the calculation period is short, if the voltage deviation change amount is small (in other words, if the absolute value of the voltage deviation change amount is large), it may indicate that the state of the battery is rapidly normalizing. Therefore, when the voltage deviation change amount is a negative number or 0, the score corresponding to the voltage deviation change amount may be set to a negative number so that the cumulative diagnostic score may be decreased. In other words, the second score table T2 may be configured to set a lower score as the voltage deviation change amount is smaller and the calculation period is shorter.

FIG. 5 is a diagram schematically showing a second score table T2 according to an embodiment of the present disclosure. Note that the calculation period section, the voltage deviation change amount section, and the score included in the embodiment of FIG. 5 are examples and values can be changed.

In the embodiment of FIG. 5, the calculation period may be set to 4 points if it is 10 days or more and less than 20 days, 3 points if it is 20 days or more and less than 30 days, 2 points if it is 30 days or more and less than 40 days, and 1 point if it is 40 days or more. Additionally, the voltage deviation change amount may be set to -1 point if it is 0 or less and more than -1, -2 points if -1 or less and more than -2, -3 points if it is -2 or less and more than -3, and -4 points if it is -3 or less.

The cumulative diagnostic score may be increased or decreased depending on the calculated voltage deviation change amount. In other words, the trend of changes in the state of the battery may be scored and expressed in the form of a cumulative diagnostic score. Therefore, the apparatus 100 for diagnosing a battery has the advantage of quantifying the state of the battery and expressing it as an objective indicator.

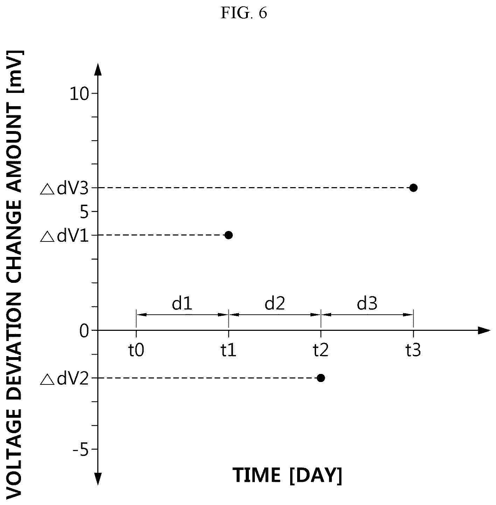

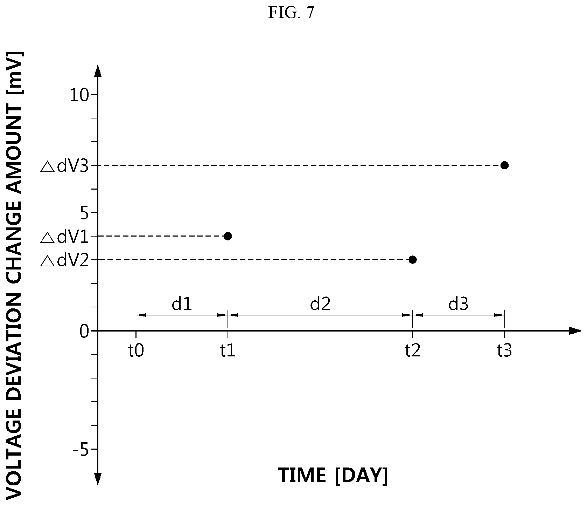

Hereinafter, a specific diagnostic example will be described with reference to FIGS. 6 and 7. As in the previous embodiment, it is assumed that the reference value is preset to 20 points.

FIG. 6 is a diagram schematically showing a first diagnostic example according to an embodiment of the present disclosure.

In the embodiment of FIG. 6, it is assumed that the first calculation period (d1) that is the difference between the t0 time point and the t1 time point, the second calculation period (d2) that is the difference between the t1 time point and the t2 time point, and the third calculation period (d3) that is the difference between the t2 time point and the t3 time point are 10 days set as a predetermined period.

The first calculation period (d1) at the t1 time point may be 10 days, and the first voltage deviation change amount (△dV1) may be 4. Since the first voltage deviation change amount (△dV1) is a positive number, the control unit 120 may determine the diagnostic score for the t1 time point according to the first score table T1. Referring to FIG. 4, since the first calculation period (d1) is 10 days, the score for the calculation period is 4 points, and since the first voltage deviation change amount (△dV1) is 4, the score for the voltage deviation change amount is 2 points. Therefore, the control unit 120 may determine the diagnostic score at the t1 time point as 8 points.

The control unit 120 may determine the cumulative diagnostic score at the t1 time point as 8 points.

The second calculation period (d2) at the t2 time point may be 10 days, and the second voltage deviation change amount (△dV2) may be -2. Since the second voltage deviation change amount (△dV2) is a negative number, the control unit 120 may determine the diagnostic score for the t2 time point according to the second score table T2. Referring to FIG. 5, since the first calculation period (d1) is 10 days, the score for the calculation period is 4 points, and since the second voltage deviation change amount (△dV2) is -2, the score for the voltage deviation change amount is -3 points. Therefore, the control unit 120 may determine the diagnostic score at the t2 time point as -12 points.

The control unit 120 may determine the cumulative diagnostic score at the t2 time point as -4 points by calculating the formula "8 - 12".

The third calculation period (d3) at the t3 time point may be 10 days, and the third voltage deviation change amount (△dV3) may be 6. Since the third voltage deviation change amount (△dV3) is a positive number, the control unit 120 may determine the diagnostic score for the t3 time point according to the first score table T1. Referring to FIG. 4, since the third calculation period (d3) is 10 days, the score for the calculation period is 4 points, and since the third voltage deviation change amount (△dV3) is 6, the score for the voltage deviation change amount is 2 points. Therefore, the control unit 120 may determine the diagnostic score at the t3 time point as 8 points.

The control unit 120 may determine the cumulative diagnostic score at the t3 time point as 4 points by calculating the formula "8 - 12 + 8".

Accordingly, the control unit 120 may diagnose the state of the battery according to the embodiment of FIG. 6 as a normal state.

FIG. 7 is a diagram schematically showing a second diagnostic example according to an embodiment of the present disclosure.

In the embodiment of FIG. 7, it is assumed that the first calculation period (d1), which is the difference between the t0 time point and the t1 time point, and the third calculation period (d3), which is the difference between the t2 time point and the t3 time point, are 10 days set as a predetermined period. Also, it is assumed that the second calculation period (d2), which is the difference between the t1 time point and the t2 time point, is 20 days.

The first calculation period (d1) at the t1 time point may be 10 days, and the first voltage deviation change amount (△dV1) may be 4. Since the first voltage deviation change amount (△dV1) is a positive number, the control unit 120 may determine the diagnostic score for the t1 time point according to the first score table T1. Referring to FIG. 4, since the first calculation period (d1) is 10 days, the score for the calculation period is 4 points, and since the first voltage deviation change amount (△dV1) is 4, the score for the voltage deviation change amount is 2 points. Therefore, the control unit 120 may determine the diagnostic score at the t1 time point as 8 points.

The control unit 120 may determine the cumulative diagnostic score at the t1 time point as 8 points.

The second calculation period (d2) at the t2 time point may be 20 days, and the second voltage deviation change amount (△dV2) may be 3. Since the second voltage deviation change amount (△dV2) is a positive number, the control unit 120 may determine the diagnostic score for the t2 time point according to the first score table T1. Referring to FIG. 4, since the second calculation period (d2) is 20 days, the score for the calculation period is 3 points, and since the second voltage deviation change amount (△dV2) is 3, the score for the voltage deviation change amount is 1 point. Therefore, the control unit 120 may determine the diagnostic score at the t2 time point as 3 points.

The control unit 120 may determine the cumulative diagnostic score at the t2 time point as 11 points by calculating the formula "8 + 3".

The third calculation period (d3) at the t3 time point may be 10 days, and the third voltage deviation change amount (△dV3) may be 7. Since the third voltage deviation change amount (△dV3) is a positive number, the control unit 120 may determine the diagnostic score for the t3 time point according to the first score table T1. Referring to FIG. 4, since the third calculation period (d3) is 10 days, the score for the calculation period is 4 points, and since the third voltage deviation change amount (△dV3) is 7, the score for the voltage deviation change amount is 3 points. Therefore, the control unit 120 may determine the diagnostic score at the t3 time point as 12 points.

The control unit 120 may determine the cumulative diagnostic score at the t3 time point as 23 points by calculating the formula "8 + 3 + 12".

Since the cumulative diagnostic score (23 points) at the t3 time point exceeds the reference value (20 points), the control unit 120 may diagnose that an internal micro short circuit has occurred in the battery according to the embodiment of FIG. 7.

Meanwhile, the control unit 120 may compare the relative states between the plurality of batteries based on the cumulative diagnostic score of the plurality of batteries.

Specifically, the cumulative diagnostic score may be an indicator that quantifies the state of the battery. Therefore, the control unit 120 may compare the relative states between plurality of batteries through comparison of the cumulative diagnostic scores.

For example, as the cumulative diagnostic score is lower, the relative state may be a normal state. In the embodiment of FIG. 2, it is assumed that the cumulative diagnostic score of the first battery Ba is 10 points, the cumulative diagnostic score of the second battery Bb is 15 points, the cumulative diagnostic score of the third battery Bc is 7 points, and the cumulative diagnostic score of the fourth battery Bd is 19 points. In this case, the control unit 120 may determine that the third battery Bc is in the most relatively normal state and the fourth battery Bd is in the most relatively abnormal state.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the voltage measuring unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack 10. That is, the battery pack 10 according to the present disclosure may include the above-described apparatus 100 for diagnosing a battery and at least one battery cell. Additionally, the battery pack 10 may further include electrical components (relays, fuses, etc.) and a case.

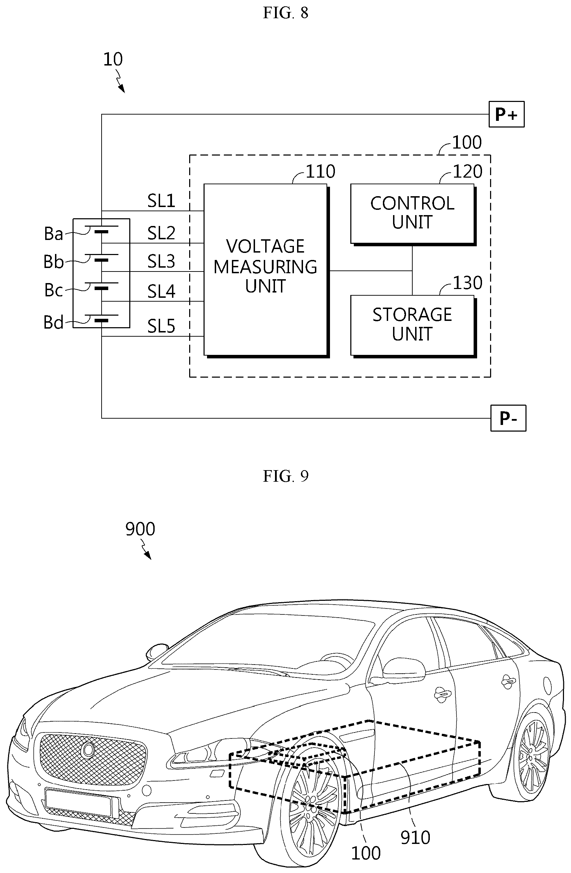

FIG. 8 is a diagram schematically showing an exemplary configuration of a battery pack 10 according to another embodiment of the present disclosure. Preferably, the battery pack 10 may include the apparatus 100 for diagnosing a battery.

The battery pack 10 may include the first battery Ba, the second battery Bb, the third battery Bc, and the fourth battery Bd. For example, in the embodiment of FIG. 8, the first battery Ba, the second battery Bb, the third battery Bc, and the fourth battery Bd may be connected in series. Note that the number of batteries included in the battery pack 10 and the connection relationship (series and/or parallel) of the batteries are not limited by the embodiment of FIG. 8.

The positive electrode terminal of the first battery Ba may be connected to the positive electrode terminal P+ of the battery pack 10, and the negative electrode terminal of the fourth battery Bd may be connected to the negative electrode terminal P- of the battery pack 10.

The measuring unit 20 may be connected to a first sensing line SL1, a second sensing line SL2, a third sensing line SL3, a fourth sensing line SL4, and a fifth sensing line SL5.

Specifically, the measuring unit 110 may be connected to the positive electrode terminal of the first battery Ba through the first sensing line SL1, and may be connected to the negative electrode terminal of the first battery Ba through the second sensing line SL2. The measuring unit 110 may measure the voltage of the first battery Ba based on the voltage measured at each of the first sensing line SL1 and the second sensing line SL2.

Likewise, the voltage measuring unit 110 may measure the voltage of the second battery Bb through the second sensing line SL2 and the third sensing line SL3, measure the voltage of the third battery Bc through the third sensing line SL3 and the fourth sensing line SL4, and measure the voltage of the fourth battery Bd through the fourth sensing line SL4 and the fifth sensing line SL5.

An external device may be connected to the positive electrode terminal P+ and the negative electrode terminal P- of the battery pack 10. For example, the external device may be a motor of an electric vehicle that receives power from the battery pack 10. As another example, the external device may be a charging device for charging the battery pack 10.

FIG. 9 is a diagram schematically showing a vehicle 900 according to another embodiment of the present disclosure.

Referring to FIG. 9, the battery pack 910 according to an embodiment of the present disclosure may be included in the vehicle 900 such as an electric vehicle (EV) or a hybrid vehicle (HV). Additionally, the battery pack 910 may drive the vehicle 900 by supplying power to the motor through an inverter provided in the vehicle 900. Additionally, the battery pack 910 may include the apparatus 100 for diagnosing a battery according to an embodiment of the present disclosure.

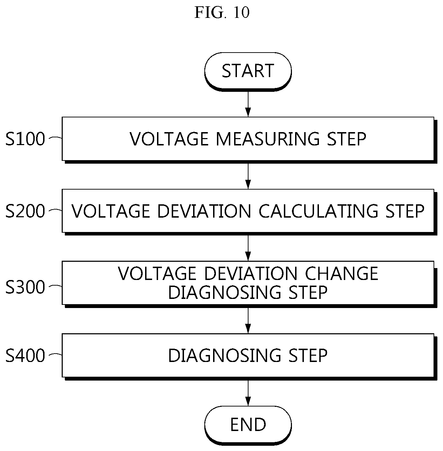

FIG. 10 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

The voltage measuring step (S100) is a step of measuring voltages of a plurality of batteries, and may be performed by the voltage measuring unit 110.

For example, the voltage measuring unit 110 may measure the voltage of each plurality of batteries.

In the embodiment of FIG. 2, the voltage measuring unit 110 may measure the voltages of the first battery Ba, the second battery Bb, the third battery Bc, and the fourth battery Bd as Va, Vb, Vc, and Vd.

The voltage deviation calculating step (S200) is a step for calculating the voltage deviation of the plurality of batteries, and may be performed by the control unit 120.

For example, the control unit 120 may calculate the average voltage of the plurality of batteries. In addition, the control unit 120 may calculate the voltage deviation of each of the plurality of batteries by calculating the difference between the calculated average voltage and the voltage of each of the plurality of batteries.

In the embodiment of FIG. 2, the control unit 120 may calculate the average voltage of the first battery Ba, the second battery Bb, the third battery Bc, and the fourth battery Bd as Vavg. The control unit 120 may calculate the voltage deviation of the first battery Ba, the second battery Bb, the third battery Bc, and the fourth battery Bd as dVa, dVb, dVc and dVd by calculating the difference between the voltage of the first battery Ba, the second battery Bb, the third battery Bc, and the fourth battery Bd and the average voltage.

The voltage deviation change amount calculating step (S300) is a step for calculating the voltage deviation change amount for each of the plurality of batteries, and may be performed by the control unit 120.

For example, the control unit 120 may calculate the voltage deviation change amount between the voltage deviation calculated at the previous time point and the voltage deviation calculated at the current time point for each of the plurality of batteries.

Preferably, the difference between the previous time point and the current time point may be a predetermined period or more. For example, if the predetermined period is set to 10 days, the previous time point and the current time point may differ by 10 days or more.

The diagnosing step (S400) is a step of diagnosing the state of each of the plurality of batteries based on the voltage deviation change amount and the calculation period of the voltage deviation change amount, and may be performed by the control unit 120.

For example, the control unit 120 may be configured to determine a diagnostic score for each of the plurality of batteries from the voltage deviation change amount and the calculation period based on a preset score table. Preferably, the control unit 120 may be configured to diagnose the state of each battery according to the cumulative diagnostic score of each of the plurality of batteries. The control unit 120 may diagnose that an internal micro short circuit has occurred in the battery if the cumulative diagnostic score is higher than or equal to a preset reference value. Conversely, the control unit 120 may diagnose the battery as normal if the cumulative diagnostic score is less than the preset reference value.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications. The invention is defined by the claims.

### (Explanation of reference signs)

10: battery pack
100: apparatus for diagnosing a battery
110: voltage measuring unit
120: control unit
130: storage unit
900: vehicle
910: battery pack
Ba: first battery
Bb: second battery
Bc: third battery
Bd: fourth battery

## Claims

1. An apparatus for diagnosing a battery, comprising:
a voltage measuring unit (110) configured to measure voltages of a plurality of batteries; and
a control unit (120) configured to calculate a voltage deviation of the plurality of batteries, calculate a voltage deviation change amount of each of the plurality of batteries, and diagnose a state of each of the plurality of batteries based on the voltage deviation change amount and a calculation period of the voltage deviation change amount, **characterized in that** the control unit (120) is configured to determine a diagnostic score of each of the plurality of batteries from the voltage deviation change amount and the calculation period based on a preset score table, and diagnose the state of each battery according to a cumulative diagnostic score of each of the plurality of batteries.

2. The apparatus for diagnosing a battery according to claim 1,
wherein the control unit (120) is configured to determine a battery of which the cumulative diagnostic score is higher than or equal to a preset reference value among the plurality of batteries and diagnose that an internal micro short circuit has occurred in the determined battery.

3. The apparatus for diagnosing a battery according to claim 1,
wherein the control unit (120) is configured to determine a corresponding diagnostic score by substituting the voltage deviation change amount and the calculation period in the score table.

4. The apparatus for diagnosing a battery according to claim 1,
wherein the control unit (120) is configured to determine the diagnostic score based on a first score table when the voltage deviation change amount is a positive number and determine the diagnostic score based on a second score table when the voltage deviation change amount is a negative number or 0.

5. The apparatus for diagnosing a battery according to claim 4,
wherein the first score table is configured so that a higher score is set as the voltage deviation change amount is higher and the calculation period is shorter.

6. The apparatus for diagnosing a battery according to claim 4,
wherein the second score table is configured so that a lower score is set as the voltage deviation change amount is lower and the calculation period is shorter.

7. The apparatus for diagnosing a battery according to claim 1,
wherein the control unit (120) is configured to calculate a current voltage deviation of the plurality of batteries at a second time point after a predetermined period has elapsed from a first time point when the voltage deviation is calculated, and calculate the voltage deviation change amount by calculating a difference between the voltage deviation and the current voltage deviation.

8. The apparatus for diagnosing a battery according to claim 1,
wherein the control unit (120) is configured to calculate a current voltage deviation of the plurality of batteries at a second time point after a predetermined period has elapsed from the first time point when the voltage deviation is calculated, and calculate the calculation period by calculating a difference between the first time point and the second time point.

9. The apparatus for diagnosing a battery according to claim 1,
wherein the control unit (120) is configured to calculate an average voltage of the plurality of batteries, and calculate a voltage deviation of each of the plurality of batteries by calculating a difference between the calculated average voltage and the voltage of each of the plurality of batteries.

10. A battery pack (10), comprising the apparatus for diagnosing a battery according to any one of claims 1 to 9.

11. A vehicle, comprising the apparatus for diagnosing a battery according to any one of claims 1 to 9.

12. A method for diagnosing a battery, comprising:
a voltage measuring step (S100) of measuring voltages of a plurality of batteries;
a voltage deviation calculating step (S200) of calculating a voltage deviation of the plurality of batteries;
a voltage deviation change amount calculating step (S300) of calculating a voltage deviation change amount of each of the plurality of batteries; and
a diagnosing step (S400) of diagnosing a state of each of the plurality of batteries based on the voltage deviation change amount and a calculation period of the voltage deviation change amount, **characterized in** comprising a determination of a diagnostic score of each of the plurality of batteries from the voltage deviation change amount and the calculation period based on a preset score table, and diagnosing the state of each battery according to a cumulative diagnostic score of each of the plurality of batteries.

## Patentansprüche

1. Einrichtung zur Diagnose einer Batterie, umfassend:
eine Spannungsmesseinheit (110), die konfiguriert ist, um Spannungen einer Vielzahl von Batterien zu messen; und
eine Steuereinheit (120), die konfiguriert ist, um eine Spannungsabweichung der Vielzahl von Batterien zu berechnen, einen Betrag der Spannungsabweichungsänderung jeder der Vielzahl von Batterien zu berechnen, und einen Zustand jeder der Vielzahl von Batterien basierend auf dem Betrag der Spannungsabweichungsänderung und einem Berechnungszeitraum des Betrags der Spannungsabweichungsänderung zu diagnostizieren, **dadurch gekennzeichnet, dass** die Steuereinheit (120) konfiguriert ist, um eine Diagnosepunktzahl jeder der Vielzahl von Batterien aus dem Betrag der Spannungsabweichungsänderung und dem Berechnungszeitraum basierend auf einer voreingestellten Punktzahltabelle zu bestimmen, und den Zustand jeder Batterie gemäß einer kumulativen Diagnosepunktzahl jeder der Vielzahl von Batterien zu diagnostizieren.

2. Einrichtung zur Diagnose einer Batterie nach Anspruch 1, wobei die Steuereinheit (120) konfiguriert ist, um eine Batterie zu bestimmen, deren kumulative Diagnosepunktzahl höher als oder gleich einem voreingestellten Referenzwert unter der Vielzahl von Batterien ist, und zu diagnostizieren, dass in der bestimmten Batterie ein interner Mikrokurzschluss aufgetreten ist.

3. Einrichtung zur Diagnose einer Batterie nach Anspruch 1, wobei die Steuereinheit (120) konfiguriert ist, um eine entsprechende Diagnosepunktzahl durch Ersetzen des Betrags der Spannungsabweichungsänderung und des Berechnungszeitraums in die Punktzahltabelle zu bestimmen.

4. Einrichtung zur Diagnose einer Batterie nach Anspruch 1, wobei die Steuereinheit (120) konfiguriert ist, um die Diagnosepunktzahl basierend auf einer ersten Punktzahltabelle zu bestimmen, wenn der Betrag der Spannungsabweichungsänderung eine positive Zahl ist, und die Diagnosepunktzahl basierend auf einer zweiten Punktzahltabelle zu bestimmen, wenn der Betrag der Spannungsabweichungsänderung eine negative Zahl oder 0 ist.

5. Einrichtung zur Diagnose einer Batterie nach Anspruch 4, wobei die erste Punktzahltabelle konfiguriert ist, sodass eine höhere Punktzahl festgelegt wird, wenn der Betrag der Spannungsabweichungsänderung höher ist und der Berechnungszeitraum kürzer ist.

6. Einrichtung zur Diagnose einer Batterie nach Anspruch 4, wobei die zweite Punktzahltabelle konfiguriert ist, sodass eine niedrigere Punktzahl festgelegt wird, wenn der Betrag der Spannungsabweichungsänderung niedriger ist und der Berechnungszeitraum kürzer ist.

7. Einrichtung zur Diagnose einer Batterie nach Anspruch 1, wobei die Steuereinheit (120) konfiguriert ist, um eine aktuelle Spannungsabweichung der Vielzahl von Batterien zu einem zweiten Zeitpunkt zu berechnen, nachdem ein vorbestimmter Zeitraum von einem ersten Zeitpunkt an verstrichen ist, an dem die Spannungsabweichung berechnet wird, und den Betrag der Spannungsabweichungsänderung durch Berechnen einer Differenz zwischen der Spannungsabweichung und der aktuellen Spannungsabweichung zu berechnen.

8. Einrichtung zur Diagnose einer Batterie nach Anspruch 1, wobei die Steuereinheit (120) konfiguriert ist, um eine aktuelle Spannungsabweichung der Vielzahl von Batterien zu einem zweiten Zeitpunkt zu berechnen, nachdem ein vorbestimmter Zeitraum von einem ersten Zeitpunkt an verstrichen ist, an dem die Spannungsabweichung berechnet wird, und den Berechnungszeitraum durch Berechnen einer Differenz zwischen dem ersten Zeitpunkt und dem zweiten Zeitpunkt zu berechnen.

9. Einrichtung zur Diagnose einer Batterie nach Anspruch 1, wobei die Steuereinheit (120) konfiguriert ist, um eine mittlere Spannung der Vielzahl von Batterien zu berechnen und eine Spannungsabweichung jeder der Vielzahl von Batterien durch Berechnen einer Differenz zwischen der berechneten mittleren Spannung und der Spannung jeder der Vielzahl von Batterien zu berechnen.

10. Batteriepack (10), umfassend die Einrichtung zur Diagnose einer Batterie nach einem der Ansprüche 1 bis 9.

11. Fahrzeug, umfassend die Einrichtung zur Diagnose einer Batterie nach einem der Ansprüche 1 bis 9.

12. Verfahren zur Diagnose einer Batterie, umfassend:
einen Spannungsmessschritt (S100) zum Messen von Spannungen einer Vielzahl von Batterien;
einen Spannungsabweichungs-Berechnungsschritt (S200) zum Berechnen einer Spannungsabweichung der Vielzahl von Batterien;
einen Schritt zum Berechnen des Betrags der Spannungsabweichungsänderung (S300) zum Berechnen eines Betrags der Spannungsabweichungsänderung jeder der Vielzahl von Batterien; und
einen Diagnoseschritt (S400) zum Diagnostizieren eines Zustands jeder der Vielzahl von Batterien basierend auf dem Betrag der Spannungsabweichungsänderung und einem Berechnungszeitraum des Betrags der Spannungsabweichungsänderung, **dadurch gekennzeichnet, dass** er ein Bestimmen einer Diagnosepunktzahl jeder der Vielzahl von Batterien aus dem Betrag der Spannungsabweichungsänderung und dem Berechnungszeitraum basierend auf einer voreingestellten Punktzahltabelle und Diagnostizieren des Zustands jeder Batterie gemäß einer kumulativen Diagnosepunktzahl jeder der Vielzahl von Batterien umfasst.

## Revendications

1. Dispositif de diagnostic d'une batterie, comprenant :
une unité de mesure de tension (110) configurée pour mesurer des tensions d'une pluralité de batteries ; et
une unité de commande (120) configurée pour calculer un écart de tension de la pluralité de batteries, calculer une quantité de changement d'écart de tension de chacune de la pluralité de batteries, et diagnostiquer un état de chacune de la pluralité de batteries sur la base de la quantité de changement d'écart de tension et d'une période de calcul de la quantité de changement d'écart de tension, **caractérisé en ce que** l'unité de commande (120) est configurée pour déterminer un score de diagnostic de chacune de la pluralité de batteries à partir de la quantité de changement d'écart de tension et de la période de calcul sur la base d'un tableau de scores prédéfini, et diagnostiquer l'état de chaque batterie selon un score de diagnostic cumulé de chacune de la pluralité de batteries.

2. Le dispositif de diagnostic d'une batterie selon la revendication 1, dans lequel l'unité de commande (120) est configurée pour déterminer une batterie dont le score de diagnostic cumulé est supérieur ou égal à une valeur de référence prédéfinie parmi la pluralité de batteries et pour diagnostiquer qu'un micro-court-circuit interne s'est produit dans la batterie déterminée.

3. Le dispositif de diagnostic d'une batterie selon la revendication 1, dans lequel l'unité de commande (120) est configurée pour déterminer un score de diagnostic correspondant en substituant la quantité de changement d'écart de tension et la période de calcul dans le tableau de scores.

4. Le dispositif de diagnostic d'une batterie selon la revendication 1, dans lequel l'unité de commande (120) est configurée pour déterminer le score de diagnostic sur la base d'un premier tableau de scores lorsque la quantité de changement d'écart de tension est un nombre positif et déterminer le score de diagnostic sur la base d'un deuxième tableau de scores lorsque la quantité de changement d'écart de tension est un nombre négatif ou 0.

5. Le dispositif de diagnostic d'une batterie selon la revendication 4, dans lequel le premier tableau de scores est configuré de sorte qu'un score plus élevé est défini lorsque la quantité de changement d'écart de tension est plus élevée et que la période de calcul est plus courte.

6. Le dispositif de diagnostic d'une batterie selon la revendication 4, dans lequel le deuxième tableau de scores est configuré de sorte qu'un score plus bas est défini lorsque la quantité de changement d'écart de tension est plus faible et que la période de calcul est plus courte.

7. Le dispositif de diagnostic d'une batterie selon la revendication 1, dans lequel l'unité de commande (120) est configurée pour calculer un écart de tension actuel de la pluralité de batteries à un second instant après qu'une période prédéterminée s'est écoulée depuis un premier instant où l'écart de tension est calculé, et calculer la quantité de changement d'écart de tension en calculant une différence entre l'écart de tension et l'écart de tension actuel.

8. Le dispositif de diagnostic d'une batterie selon la revendication 1, dans lequel l'unité de commande (120) est configurée pour calculer un écart de tension actuel de la pluralité de batteries à un second instant après qu'une période prédéterminée s'est écoulée depuis un premier instant où l'écart de tension est calculé, et calculer la période de calcul en calculant une différence entre le premier instant et le second instant.

9. Le dispositif de diagnostic d'une batterie selon la revendication 1, dans lequel l'unité de commande (120) est configurée pour calculer une tension moyenne de la pluralité de batteries, et calculer un écart de tension de chacune de la pluralité de batteries en calculant une différence entre la tension moyenne calculée et la tension de chacune de la pluralité de batteries.

10. Un bloc-batterie (10), comprenant le dispositif de diagnostic d'une batterie selon l'une quelconque des revendications 1 à 9.

11. Un véhicule, comprenant le dispositif de diagnostic d'une batterie selon l'une quelconque des revendications 1 à 9.

12. Procédé de diagnostic d'une batterie, comprenant :
une étape de mesure de tension (S100) consistant à mesurer les tensions d'une pluralité de batteries ;
une étape de calcul d'écart de tension (S200) consistant à calculer un écart de tension de la pluralité de batteries ;
une étape de calcul de quantité de changement d'écart de tension (S300) consistant à calculer une quantité de changement d'écart de tension de chacune de la pluralité de batteries ; et
une étape de diagnostic (S400) consistant à diagnostiquer un état de chacune de la pluralité de batteries sur la base de la quantité de changement d'écart de tension et d'une période de calcul de la quantité de changement d'écart de tension, **caractérisé en ce qu'**il comprend une détermination d'un score de diagnostic de chacune de la pluralité de batteries à partir de la quantité de changement d'écart de tension et de la période de calcul sur la base d'un tableau de scores prédéfini, et le diagnostic de l'état de chaque batterie selon un score de diagnostic cumulé de chacune de la pluralité de batteries.
